# EUROPEAN PATENT APPLICATION

(11) **EP 0 859 466 A1**
(43) Date of publication of application: **19.08.1998**
(21) Application number: 98102441.7
(22) Date of filing: 12.02.1998
(51) Int. Cl.: H03J 7/02

(54) **Digital AFC circuit having a rounding circuit**

(30) Priority: 12.02.1997 JP 28046/97
(71) Applicant: NEC CORPORATION, Tokyo (JP)
(72) Inventor: Ishii, Tatsuya, Minato-ku, Tokyo (JP)
(74) Representative: Betten & Resch

(57) **Abstract**

In a digital AFC circuit, the frequency difference between a digital input signal and a digital reference signal is detected. Every "k" symbols of the signal representing the detected frequency difference are integrated and then divided by the integer "k" to produce a quotient having an integral part and a fractional part. To obtain a high precision AFC output, the quotient is then rounded by shifting the fractional part so that it aligns with a portion of the integral part and adding it to the integral part.

## Description

### BACKGROUND OF THE INVENTION

### Field of the Invention

The present invention relates to a digital automatic frequency control (AFC) circuit to be used in the demodulator of radio communication equipment. The present invention is particularly useful for synchronous detectors.

### Description of the Related Art

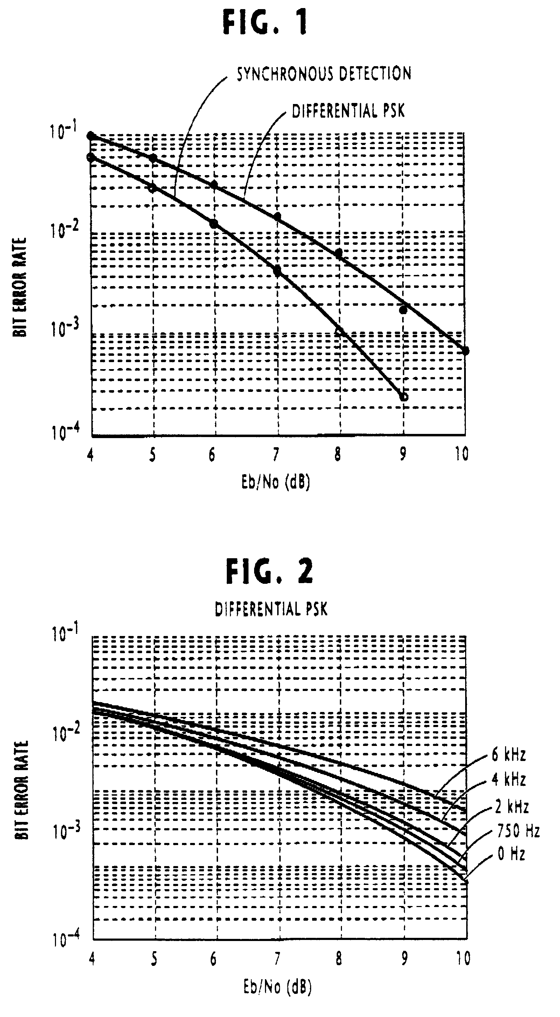

In digital radio transmission systems, the current digital modulation/demodulation technique such as π/4-shift QPSK uses either differential phase-shift keying (noncoherent PSK) or synchronous detection (coherent PSK) as a demodulation scheme. In the differential phase-shift keying, received symbols are decoded as "0" when there is no phase difference between successive timeslots and as "1" when there is a phase difference of 180 radians between them. In the synchronous detection, the receiver first extracts the clock timing of transmitted signal to recover its carrier and uses it as a reference phase for detecting the transmitted information symbols. In the differential PSK receiver, the reference phase is the phase of the previous timeslot which is usually contaminated with noise and distortion, whereas, in the synchronous detector, the recovered carrier is free from noise and distortion. Therefore, the bit error rate (BER) vs. power to noise ratio (Eb/No) of the differential PSK receiver is higher than that of the synchronous detector as shown in Fig. 1. Despite its high bit error rate, the differential PSK receiver is robust to fading and easy to implement. Because of these characteristics the differential PSK scheme is currently preferred to synchronous detection for mobile communication systems.

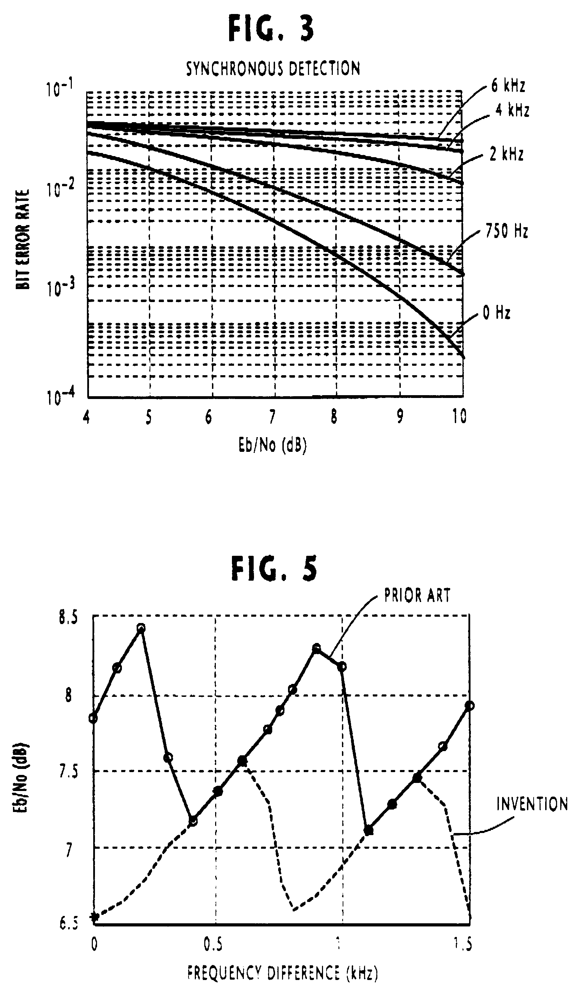

With the proliferation of mobile communications, there is a need to meet future demands for high quality mobile communications. Because of the noise-free characteristic, synchronous detection is likely to become a key to the future mobile communications. Although the BER vs. Eb/No characteristics of differential PSK systems can be improved as shown in Fig. 2, no improvement cannot be expected of synchronous detectors as shown in Fig. 3 if the frequency difference between transmit and receive sites is grater than 2 kHz. If the symbol rate is 192 kbps and each symbol is represented by 8 bits, the frequency difference can be compensated for with a minimum unit of 750 Hz (= 192,000/2⁸). Due to the presence of noise, frequency difference of significantly higher than 750 Hz will be produced in synchronous detectors as is seen from Fig. 3.

On the other hand, digital automatic frequency control (AFC) circuits are used in the mobile communication systems to compensate for the frequency difference between base and mobile stations. The digital AFC circuit usually comprises a digital frequency difference detector and a digital averaging circuit that integrates several symbols of the frequency difference signal from the detector to produce an integrated value and divides it by the number of such symbols to produce a quotient representing an average value of the frequency difference. If the quotient has a fractional part, it is simply truncated and the integral part is used as the output of the AFC circuit.

To implement a high quality mobile communication system using synchronous detection, high precision digital AFC circuitry will be required to make up for the deficiency of synchronous detection.

### SUMMARY OF THE INVENTION

It is therefore an object of the present invention to provide a high precision digital AFC circuit.

According to the present invention, the high precision digital AFC circuit is obtained by the combination of a digital frequency difference detector for detecting a frequency difference between a digital input signal and a digital reference signal and producing therefrom a digital output signal representative of the frequency difference, a digital integrator for integrating every "k" symbols of the digital output signal and producing therefrom a digital integrated signal, a digital division circuit for dividing the digital integrated signal by the integer "k" and producing therefrom a digital quotient signal having an integral part and a fractional part, and a digital rounding circuit for shifting the fractional part so that the fractional part aligns with a portion of the integral part and adding the aligned fractional part to the integral part.

### BRIEF DESCRIPTION OF THE DRAWINGS

The present invention will be described in further detail with reference to the accompanying drawings, in which:
Fig. 1 is a graphic representation of the bit error rate (BER) vs. power/noise ratio (Eb/No) characteristics of differential phase-shift keying and synchronous detection;
Fig. 2 is a graphic representation of the BER vs. Eb/No characteristics of differential phase-shift keying systems for a number of frequency differences, using the conventional digital AFC circuit;
Fig. 3 is a graphic representation of the BER vs. Eb/No characteristics of synchronous detectors for a number of frequency differences, using the conventional digital AFC circuit;
Fig. 4 is a block diagram of an automatic frequency control circuit of the present invention; and
Fig. 5 is a graphic representation of the BER vs. frequency difference characteristics of a synchronous detector using the digital AFC circuit of the present invention in comparison with those of a synchronous detector using the conventional digital AFC circuit.

### DETAILED DESCRIPTION

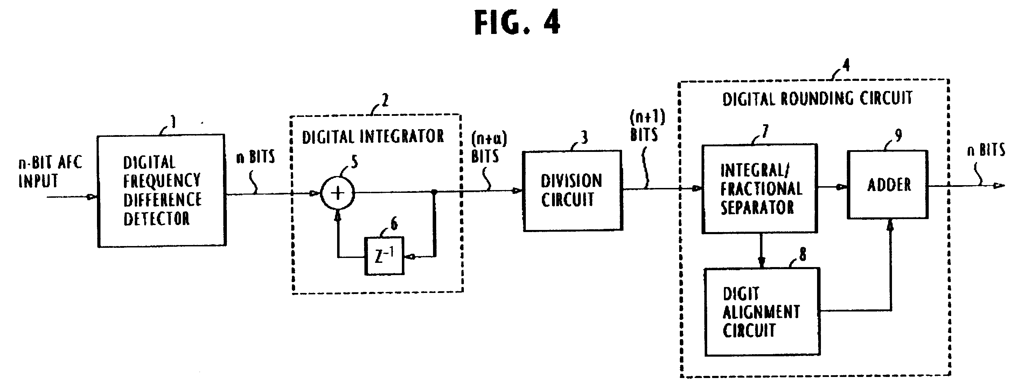

In Fig. 4, a digital automatic frequency control (AFC) circuit of the present invention for a mobile communication system comprises a digital frequency difference detector 1, a digital integrator circuit 2, a digital division circuit 3 and a digital rounding circuit 4.

Digital frequency difference detector 1 receives an n-bit baseband AFC input signal and produces an n-bit signal indicating the frequency difference between the local oscillator of a mobile station and the carrier transmitted from a base station. This is accomplished by detecting the timing of a preamble sequence of the baseband signal and subtracting the known bit pattern of the preamble sequence from the baseband signal.

Digital integrator 2 integrates consecutive "k" symbols of the n-bit frequency difference signal and repeats this process to produce an (n + α)-bit signal for every "k" symbols. Typically, the integer "k" is sixteen in the case of the Personal Handyphone System to take account of the length of its preamble sequence. As the number of such symbols within the integration interval increases, the noise of the frequency signal is cancelled to reduce its the adverse effect. This integrator comprises an adder 5 and a symbol-delay element 6, the arrangement being such that the adder 5 receives the n-bit input from the frequency difference detector 1, adds it to the output of the delay element 6 to produce an (n + α) bit output and feeds it back to the delay element 6. Therefore, one-symbol delayed n-bit frequency difference data is summed with the next symbol from the frequency difference detector 1 and this process is repeated over every sixteen consecutive symbols. In order to prevent overflow, the integer α is determined such that the total number of bits (n + α) can accommodate a desired range of frequency differences. If the digital AFC circuit is used in a mobile communication system where the carrier frequency is 1.9 GHz and the sampling frequency is 192 kHz (equal to symbol rate), one bit is considered to be sufficient for the α-value if a frequency difference of about 5.7 kHz (=3 ppm) is to be compensated for in the presence of noise.

The (n + α)-bit integrator output of the digital integrator 2 is then divided by the number of symbols contained in the integration interval, i.e., the integer "16". Since the division of a binary number is equivalent to the process of shifting the decimal point of a dividend to the left by an amount equal to a divisor, the division circuit 3 shifts the (n + α) bits by 4-bit positions to the left, so that the output of the division circuit is represented by an integral part and a fractional part of the divided number. Note that the second and lower-order digits of the fractional part are deleted, so that the output of the division circuit 3 is represented by the integral part and the first digit of the fractional part. Therefore, the output of the division circuit 3 indicates an average value of the frequency differences over a several-symbol interval and is represented by n + 1 bits.

The output of the division circuit 3 is applied to the digital rounding circuit 4. Analogous to the decimal number system, the rounding circuit 4 rounds up a decimal number if the first decimal place of its fractional part is equal to "5", "6", "7", "8" or "9" and rounds it down if that first decimal place is equal to "4", "3", "2", "1" or "0". In the binary number system, the digital rounding circuit 4 adds the first (most significant) bit of the fractional part to the least significant bit of the integral part if that first bit is equal to "1", or deletes that first bit if it is equal to "0". As illustrated, this rounding circuit comprises an integral/fractional separator 7, a bit alignment circuit 8 and an adder 9. The separator 7 receives the output of the division circuit 3 and separates it into the n-bit integral component and the one bit fractional component, these components being respectively supplied to the adder 9 and the bit alignment circuit 8. The decimal point of the fractional component is shifted one bit position to the right so that it aligns with the least significant bit of the integral component. The output of the bit alignment circuit 8 is summed in the adder 9 with the least significant bit of the integral part to produce an n-bit frequency difference signal.

If the (n+1)-bit input signal from the division circuit 3 is a 5-bit signal represented by "0101.0", the binary "0" of the fractional part is aligned with the binary "1" of the least significant position of the integral part and summed with the integral part, giving an output signal "0101". If the 5-bit signal is "0101.1", the binary "1" of the fractional part is aligned with the least significant bit of the integral part and summed with it, giving an output signal "0110". The output signal of the adder 9 is supplied to a synchronous detector, not shown.

Fig. 5 shows computer simulations of the BER vs. frequency difference characteristics of a synchronous detector using the AFC circuit of this invention in comparison with those of the synchronous detector using the conventional AFC circuit, with the synchronous detector operating on a signal sampled at 192 kbps and quantized into 8-bits per phase. Since the minimum frequency with which the AFC circuit operates to compensate for frequency differences is 750 Hz, the BER vs. Eb/No characteristics vary at intervals of 750 Hz as seen from Fig. 5.

The computer simulations indicate that there is an improvement of as much as 1.5 dB by the use of the AFC circuit of this invention over the prior art. Thus, the digital AFC circuit of this invention enables synchronous detection systems to be used in multipath fading communication channels.

## Claims

1. A digital AFC circuit for a demodulator, comprising:
a digital frequency difference detector for detecting a frequency difference between a digital input signal and a digital reference signal and producing therefrom a digital output signal representative of the frequency difference;
a digital integrator for integrating every "k" symbols of said digital output signal and producing therefrom a digital integrated signal;
a digital division circuit for dividing the digital integrated signal by the integer "k" and producing therefrom a digital quotient signal having an integral part and a fractional part; and
a digital rounding circuit for shifting the fractional part so that the fractional part aligns with a portion of the integral part and adding the aligned fractional part to the integral part.

2. A digital AFC circuit as claimed in claim 1, wherein the fractional part is represented by one bit.

3. A digital AFC circuit as claimed in claim 1, wherein said demodulator is a synchronous detector.

4. A method of producing a digital frequency difference signal, comprising the steps of:
a) detecting a frequency difference between a digital input signal and a digital reference signal and producing therefrom a digital output signal representative of the frequency difference;
b) integrating every "k" symbols of said digital output signal and producing therefrom a digital integrated signal;
c) dividing the digital integrated signal by the integer "k" and producing therefrom a digital quotient signal having an integral part and a fractional part; and
d) shifting the fractional part so that the fractional part aligns with a portion of the integral part and adding the aligned fractional part to the integral part.

5. The method of claim 1, wherein the fractional part is represented by one bit.

6. The method of claim 1, further comprising the step of using the digital quotient signal of step (d) in a synchronous detector.
